# EUROPEAN PATENT APPLICATION

(11) **EP 4 583 445 A1**
(43) Date of publication of application: **09.07.2025**
(21) Application number: 23859175.4
(22) Date of filing: 18.08.2023
(51) Int. Cl.: H04L 5/00, H04J 3/06

(54) **DELAY CALIBRATION APPARATUS AND DELAY CALIBRATION METHOD**

(30) Priority: 31.08.2022 CN 202211058378
(71) Applicant: Sanechips Technology Co., Ltd., Shenzhen, Guangdong 518055 (CN)
(72) Inventor: YU, Hejie, Shenzhen, Guangdong 518055 (CN); HUANG, Xinxing, Shenzhen, Guangdong 518055 (CN)
(74) Representative: Mitola, Marco
(86) International application number: PCT/CN2023/113693
(87) International publication number: WO 2024/046141

(57) **Abstract**

Provided in the present disclosure is a delay calibration apparatus. The delay calibration apparatus comprises a delay calibration module, which comprises a coarse delay calibration unit and a precise delay calibration unit, wherein the coarse delay calibration unit is used for receiving an air interface pulse signal, and performing delay compensation on a channel associated pulse signal in a digital clock domain according to the air interface pulse signal; and the precise delay calibration unit comprises a precise delay calibration sub-unit and a phase calibration sub-unit, the precise delay calibration sub-unit being used for performing delay compensation on the channel associated pulse signal in an analog clock domain, and the phase calibration sub-unit being used for calibrating a clock domain phase. Also provided in the present disclosure is a delay calibration method.

## Description

### Cross-Reference to Related Application

The present disclosure claims priority to Chinese Patent Application No. CN202211058378.8, filed to the China National Intellectual Property Administration on August 31, 2022 and entitled "Delay Calibration Apparatus and Delay Calibration Method", the disclosure of which is hereby incorporated by reference in its entirety.

### Technical Field

Embodiments of the present disclosure relate to, but are not limited to, the technical field of communications, and in particular to a delay calibration apparatus and a delay calibration method.

### Background

With the rapid development of 5G communications in recent years, technologies such as Massive Multiple Input Multiple Output (MIMO) (which is a massive antenna technology) and Global Positioning System Pulse Per Second (GPS 1PPS) timing have improved system capacity and clock accuracy. However, precision of digital link delay in a Radio Frequency (RF) transceiver system has also been heightened due to these developments. Due to factors such as asynchronous processing across clock domains in digital links, differences in reset path lengths, and variations in integrated circuit process characteristics (such as process corners, power supply voltages, and temperatures, collectively referred to as PVT), there are differences in the delay of the digital links during initial power-up and operation. These differences manifest in the multi-antenna form of the product, necessitating data alignment processing.

Currently, a method used for this processing involves constructing special excitation data, performing dual-point sampling of digital link data, obtaining a transmission delay of the data link according to correlation algorithm analysis, and then aligning the data through correction. The data is then corrected and aligned accordingly. However, the precision of delay calibration of the double-point sampling link is limited, and the entire algorithm analysis process is relatively complex and cumbersome, with significant costs.

### Summary

The present disclosure provides a delay calibration apparatus and a delay calibration method.

In a first aspect, the embodiments of the present disclosure provide a delay calibration apparatus, including a delay calibration module. The delay calibration module includes a coarse delay calibration unit and a precise delay calibration unit. The coarse delay calibration unit is configured to receive an air interface pulse signal, and perform delay compensation on a channel associated pulse signal in a digital clock domain according to the air interface pulse signal. The precise delay calibration unit includes a precise delay calibration sub-unit and a phase calibration sub-unit. The precise delay calibration sub-unit is configured to perform delay compensation on the channel associated pulse signal in an analog clock domain after the coarse delay calibration unit performs the delay compensation on the channel associated pulse signal in the digital clock domain according to the air interface pulse signal. The phase calibration sub-unit is configured to calibrate a clock domain phase after the precise delay calibration sub-unit performs the delay compensation on the channel associated pulse signal in the analog clock domain.

In another aspect, the embodiments of the present disclosure provide a delay calibration method, applied to the delay calibration apparatus as mentioned above. The delay calibration method includes: receiving an air interface pulse signal, and performing delay compensation on a channel associated pulse signal in a digital clock domain according to the air interface pulse signal; and performing delay compensation on the channel associated pulse signal in an analog clock domain, and calibrating a clock domain phase.

### Brief Description of the Drawings

Fig. 1 is a schematic structural diagram of a delay calibration module in a delay calibration apparatus according to some embodiments of the present disclosure.
Fig. 2 is a schematic diagram of an overall structure of a delay calibration apparatus according to some embodiments of the present disclosure.
Fig. 3 is a schematic structural diagram of a second delay calibration module according to some embodiments of the present disclosure.
Fig. 4 is a schematic diagram of a delay calibration timing sequence of a Reception (RX) link according to some embodiments of the present disclosure.
Fig. 5 is a schematic structural diagram of a first delay calibration module according to some embodiments of the present disclosure.
Fig. 6 is a schematic diagram of a delay calibration timing sequence of a Transmission (TX) link according to some embodiments of the present disclosure.
Fig. 7 is a schematic structural diagram of a gate_pluse differential circuit according to some embodiments of the present disclosure.
Fig. 8 is a schematic diagram of a timing sequence of a gate_pluse differential circuit according to some embodiments of the present disclosure.
Fig. 9 is a schematic flowchart of a delay calibration method according to some embodiments of the present disclosure.
Fig. 10 is a schematic flowchart of performing delay compensation on a channel associated pulse signal in a transmission link according to some embodiments of the present disclosure.
Fig. 11 is a schematic flowchart of performing delay compensation on a channel associated pulse signal in a reception link according to some embodiments of the present disclosure.

### Detailed Description of the Embodiments

Exemplary embodiments will be described more fully below with reference to the drawings, but the exemplary embodiments may be embodied in different forms and should not be construed as limited to the embodiments described herein. Rather, the purpose of providing these embodiments is to make the present disclosure thorough and complete and to enable those having ordinary skill in the art to fully understand the scope of the present disclosure.

As used herein, the term "and/or" includes any and all combinations of one or more of associated listed items.

The terms used herein are only used for the describing specific embodiments, and are not intended to limit the present disclosure. As used herein, singular forms "one", and "the" are also intended to include plural forms as well, unless the context explicitly otherwise. It is also to be understood that the terms "include" and/or "prepared from..." used in the specification specify the existence of the feature, entirety, step, operation, element and/or component, but do not exclude the existence or addition of one or more other features, entireties, steps, operations, elements, components and/or groups.

The embodiments described herein may be described with reference to planar and/or crosssectional drawings by means of an idealized schematic diagram of the present disclosure. Therefore, the example diagrams may be modified according to manufacturing technology and/or tolerance. Therefore, the embodiments are not limited to the embodiments shown in the drawings, but include modifications to configurations based on manufacturing processes. Therefore, the areas illustrated in the drawings have schematic attributes, and the shapes of the areas shown in the drawings illustrate specific shapes of areas of elements, but are not intended to be restrictive.

Unless otherwise defined, all terms (including technical terms and scientific terms) used herein have the same meanings as commonly understood by those of ordinary in the art. It is also to be understood that the terms defined in common dictionaries should be explained as having the same meanings as those in the related art and the background of the present disclosure rather than having idealized or over-formalized meanings, unless otherwise defined clearly herein.

In the related art, double-point sampling of digital link data for delay calibration has the following disadvantages.
1. The accuracy of delay calibration of a link is limited. When the conventional two-point synchronous sampling method faces the link across clock domains, there is uncertainty in the accuracy of one clock cycle of the clock domain, and in addition, since the sampling is in a digital clock domain, the clock frequency is relatively low and a time difference of a single clock cycle occurs.
2. The whole algorithm analysis process is relatively complex and cumbersome, with significant costs. First, it is necessary to construct corresponding excitation data for processing in different scenarios of digital links of different systems; second, offline analysis cannot achieve instant application of products, and online analysis will consume a lot of software and hardware resources and increase more power consumption; and finally, whether for initialization correction in a power-on process or re-correction in a normal operation process, the overall time consumption is relatively long, which is not conducive to the rapid completion of high-precision timing of the system.

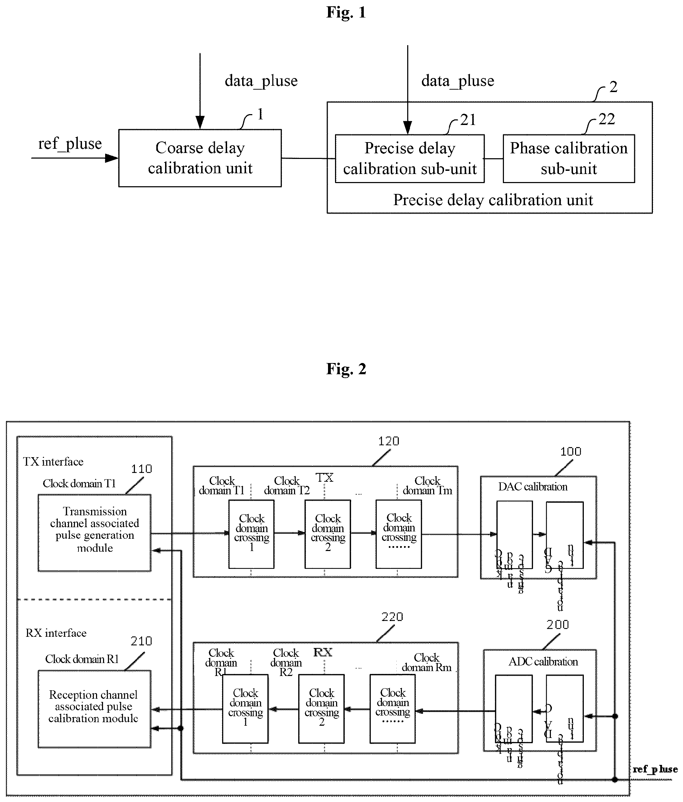

In order to solve the above problems, the embodiments of the present disclosure provide a delay calibration apparatus, including a delay calibration module. Fig. 1 is a schematic structural diagram of a delay calibration module in a delay calibration apparatus according to some embodiments of the present disclosure. As shown in Fig. 1, the delay calibration module includes a coarse delay calibration unit 10 and a precise delay calibration unit 20. The coarse delay calibration unit 10 is configured to receive an air interface pulse signal (denoted as ref_pluse), and perform delay compensation on a channel associated pulse signal (denoted as data_pluse) in a digital clock domain according to the air interface pulse signal (denoted as ref_pluse).

The precise delay calibration unit 20 includes a precise delay calibration sub-unit 21 and a phase calibration sub-unit 22. The precise delay calibration sub-unit 21 is configured to perform delay compensation on the channel associated pulse signal in an analog clock domain after the coarse delay calibration unit 22 performs the delay compensation on the channel associated pulse signal in the digital clock domain according to the air interface pulse signal.

The phase calibration sub-unit 22 is configured to calibrate a clock domain phase after the precise delay calibration sub-unit 21 performs the delay compensation on the channel associated pulse signal in the analog clock domain.

The air interface pulse signal (denoted as ref_pluse) is generated by the frequency division of a GPS 1PPS signal, which is generally an integer multiple of a cycle T and maintains a high level for a period of time. The channel associated pulse signal (denoted as data_pluse) has the same cycle as the air interface pulse signal, and maintains the high level for one cycle in the clock domain.

According to the delay calibration apparatus of the embodiments of the present disclosure, based on the air interface pulse signal, the accuracy of delay calibration may be improved to two high-frequency clock cycles by performing delay compensation in the digital clock domain and phase calibration in the analog high-frequency clock domain; by adjusting the delay of the channel associated pulse signal delay and the digital clock phase in the digital clock domain, the conventional algorithm analysis after two-point synchronous sampling is replaced, a calibration process is simplified, the calculation amount of the algorithm is reduced, and the fast and high-precision link timing is realized; and the delay calibration apparatus has a simple overall structure and may adapt to multiple channels, multiple modes, and multiple working scenarios.

Fig. 2 is a schematic diagram of an overall structure of a delay calibration apparatus according to some embodiments of the present disclosure. As shown in Fig. 2, the delay calibration apparatus includes a transmission link (denoted as TX link), and the delay calibration module includes a first delay calibration module (e.g., Digital-to-Analog Converter (DAC) calibration) 100, the first delay calibration module being located in the transmission link. The coarse delay calibration unit 10 is a first coarse delay calibration unit 101, the precise delay calibration unit 20 is a first precise delay calibration unit 201, and the channel associated pulse signal is a transmission channel associated pulse signal.

The transmission link (denoted as TX link) further includes a transmission channel associated pulse generation module 110 and a transmission link channel associated pulse transfer module 120. The transmission channel associated pulse generation module 110 is configured to receive the air interface pulse signal, and generate the transmission channel associated pulse signal according to the air interface pulse signal.

The transmission link channel associated pulse transfer module 120 is configured to perform aligned transmission on the transmission channel associated pulse signal and link data by using a data valid enable signal in multiple clock domains of the transmission link, and transmit the transmission channel associated pulse signal and link data to the first coarse delay calibration unit 101 of the first delay calibration module 100.

The transmission channel associated pulse signal is generated in the transmission channel associated pulse signal generation module 110, and reaches the first delay calibration module (DAC calibration) 100 for calibration through each clock domain of the TX link. During signal transmission, the transmission channel associated pulse signal and the link data pass through multiple clock domains of the TX link together, and perform aligned transmission by using the data valid enable signal, so that the transmission channel associated pulse signal may reflect the delay condition of the link data transmission.

As shown in Fig. 2, the delay calibration apparatus further includes a reception link (denoted as RX link), and the delay calibration module includes a second delay calibration module (e.g., Analog-to-Digital Converter (ADC) calibration) 200, the second delay calibration module 200 being located in the reception link. The channel associated pulse signal is a reception channel associated pulse signal, the precise delay calibration unit 20 is a second precise delay calibration unit 202, the coarse delay calibration unit 10 is a second coarse delay calibration unit 102, and the second coarse delay calibration unit 102 is further configured to generate the reception channel associated pulse signal (denoted as rx_data_pluse) according to the air interface pulse signal after receiving the air interface pulse signal.

The reception link (denoted as RX link) further includes a reception channel associated pulse calibration module 210 and a reception link channel associated pulse transfer module 220. The reception link channel associated pulse transfer module 220 is configured to perform aligned transmission on the reception channel associated pulse signal and link data by using a data valid enable signal in multiple clock domains of the reception link, and transmit the reception channel associated pulse signal and the link data to the reception channel associated pulse calibration module 210.

The reception channel associated pulse calibration module 210 is configured to perform delay compensation on the received channel associated pulse signal in the digital clock domain according to the air interface pulse signal.

The reception channel associated pulse signal is generated in the second delay calibration module (e.g., ADC calibration) 200, and reaches the reception channel associated pulse calibration module 210 for calibration through each clock domain of the RX link. During signal transmission, the reception channel associated pulse signal and the link data pass through multiple clock domains of the RX link together, and perform aligned transmission by using the data valid enable signal, so that the reception channel associated pulse signal may reflect the delay condition of the link data transmission.

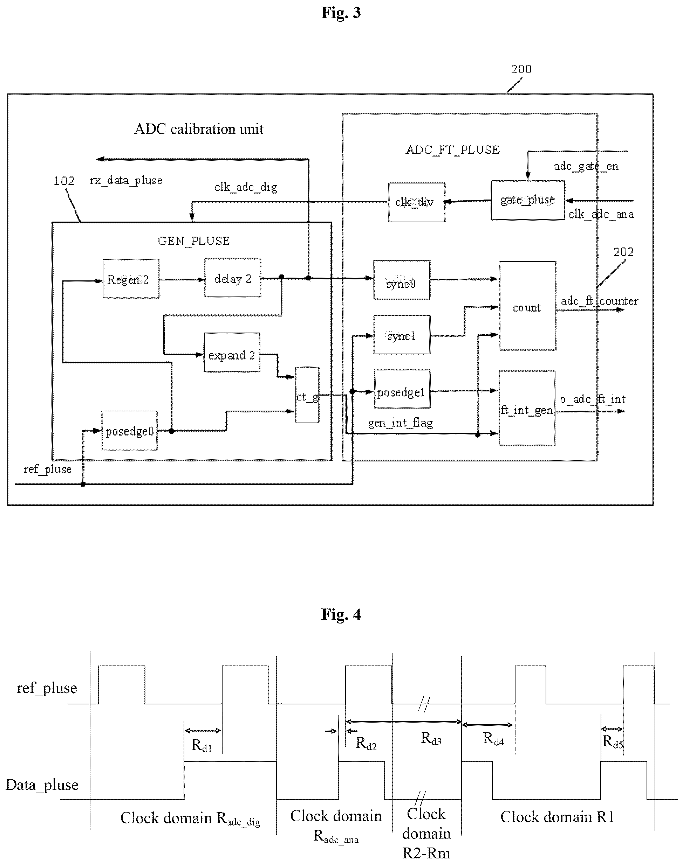

Fig. 3 is a schematic structural diagram of a second delay calibration module according to some embodiments of the present disclosure. As shown in Fig. 3, the second delay calibration module 200 includes a second coarse delay calibration unit (denoted as GEN_PLUSE) 102 and a second precise delay calibration unit (denoted as ADC_FT_PLUSE) 202.

The second coarse delay calibration unit 102 includes a second air interface pulse processing sub-unit (denoted as posedge0), a second channel associated pulse signal regeneration sub-unit (denoted as regen2), a second delay sub-unit (denoted as delay2), and a second coarse delay calibration sub-unit (denoted as ct_g). The second air interface pulse processing sub-unit (denoted as posedge0) is configured to generate a single-cycle air interface pulse signal according to a rising edge of the air interface pulse signal (denoted as ref_pluse).

The second channel associated pulse signal regeneration sub-unit (denoted as regen) is respectively connected to the second air interface pulse processing sub-unit (denoted as posedge0) and the second delay sub-unit (denoted as delay2) respectively, and is configured to reduce the single-cycle air interface pulse signal transmitted by the second air interface pulse processing sub-unit (denoted as posedge0) by a preset multiple according to a cycle ratio to generate a regenerated reception channel associated pulse signal, and transmit the regenerated reception channel associated pulse signal to the second delay sub-unit (denoted as delay2). A cycle T and a preset multiple N of the air interface pulse signal are pre-configured in the second channel associated pulse signal regeneration sub-unit (denoted as regen), and a cyclic regenerated reception channel associated pulse signal is generated according to the cycle T and the preset multiple N of the air interface pulse signal.

The second delay sub-unit (denoted as delay2) is configured to eliminate a delay between the regenerated reception channel associated pulse signal and the next air interface pulse signal to obtain a second signal, where the second signal is the regenerated received pulse signal after the delay is eliminated. After the second delay sub-unit (denoted as delay2) is configured with a delay close to the cycle T of the air interface pulse signal, successive approximation is performed by adding one beat each time. Fig. 4 is a schematic diagram of a delay calibration timing sequence of an RX link according to some embodiments of the present disclosure. As shown in Fig. 4, at this time, a delay difference Rd1 between the reception channel associated pulse signal (i.e., the second signal) and the next air interface pulse signal is an uncertain asynchronous sampling delay.

The second coarse delay calibration sub-unit (denoted as ct_g) is configured to perform a logic AND operation on the second signal and the single-cycle air interface pulse signal, perform coarse delay calibration in a case where an operation result is not 1, stop the logic AND operation until the operation result is 1, and generate a second indication signal (denoted as gen_int_flag), where the second indication signal (denoted as gen_int_flag) is configured to instruct the second precise delay calibration unit 202 to perform precise delay calibration. The second coarse delay calibration sub-unit (denoted as ct_g) triggers the coarse delay calibration interrupt each time through the rising edge of the air interface pulse signal until the result of the sum of the channel associated pulse signal and the air interface pulse signal is 1, and ct_int_flag is generated, indicating that the coarse delay calibration is completed.

In some embodiments, as shown in Fig. 3, the second coarse delay calibration unit 102 further includes a second expansion sub-unit (denoted as expand2). The second expansion sub-unit (denoted as expand2) is connected to the second delay sub-unit (denoted as delay2) and the second coarse delay calibration sub-unit (denoted as ct_g), and is configured to expand a high level length of the second signal according to one clock cycle, and transmit the expanded second signal to the second coarse delay calibration sub-unit (denoted as ct_g), so that the second coarse delay calibration sub-unit (denoted as ct_g) performs the logical AND operation on the expanded second signal and the single-cycle air interface pulse signal. The second expansion sub-unit (denoted as expand2) expands the high level length of the channel associated pulse signal (i.e., the second signal) according to one clock cycle, thereby eliminating the possible influence caused by the uncertainty of the asynchronous sampling delay difference, and ensuring that the channel associated pulse signal is earlier than the air interface pulse signal.

In conjunction with Fig. 2 and Fig. 4, the second delay calibration module 200 sends out the reception channel associated pulse signal, the reception channel associated pulse signal passes through multiple clock domains of the reception link channel associated pulse transfer module 220 in sequence to ensure that the reception channel associated pulse signal maintains a high level for one clock cycle, and is transmitted to a low-level circuit synchronously with the data, and when the reception channel associated pulse signal reaches the reception channel associated pulse calibration module 210, the difference between the reception channel associated pulse signal and the air interface pulse signal is R_{d3} to R_{d2} , where R_{d2} is the delay between the reception channel associated pulse signal and the next air interface pulse signal, and R_{d3} is a fixed link delay R_{d31} plus an uncertain clock domain crossing delay R_{d32}. Coarse delay calibration is performed in the reception channel associated pulse calibration module 210, and the coarse delay calibration process is the same as the coarse delay calibration process of the first delay calibration module 100. The final delay accuracy is R_{d5}=R_{d2}+R_{d51}, where R_{d51} is a clock cycle R1 of a clock domain of an RX interface, and R_{d2} is the sum of clock cycles T_{adc_ana} of two ADC analog clock domains.

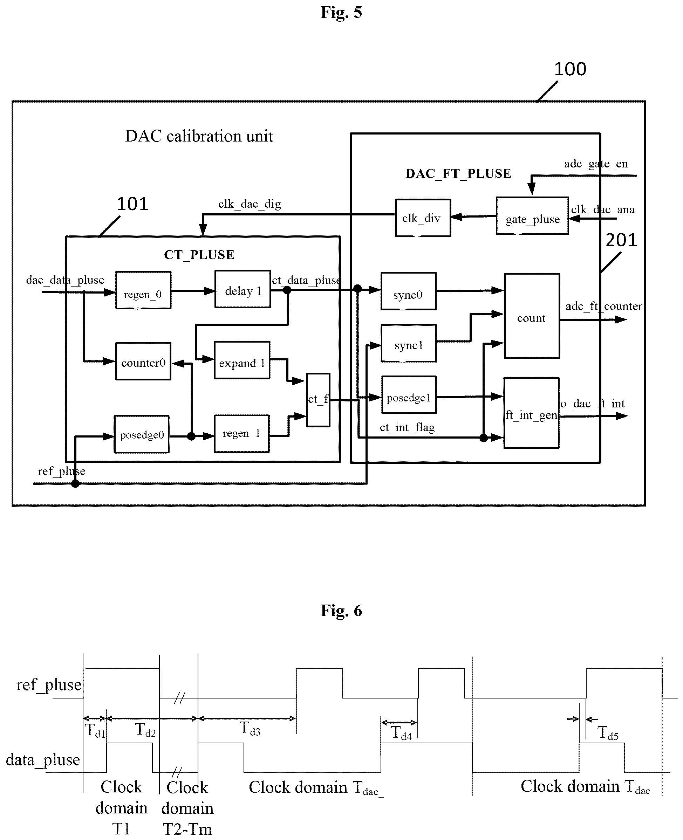

Fig. 5 is a schematic structural diagram of a first delay calibration module according to some embodiments of the present disclosure. As shown in Fig. 5, the first delay calibration module 100 includes a first coarse delay calibration unit (denoted as CT_PLUSE) 101 in a digital domain and a first precise delay calibration unit (denoted as DAC_FT_PLUSE) 201 in an analog domain.

The first coarse delay calibration unit 101 includes a first air interface pulse processing sub-unit (denoted as posedge0), a first delay sub-unit (denoted as delay1), and a first coarse delay calibration sub-unit (denoted as ct_f).

The first air interface pulse processing sub-unit (denoted as posedge0) is configured to generate the single-cycle air interface pulse signal according to the rising edge of the air interface pulse signal.

The first delay sub-unit (denoted as delay1) is configured to eliminate a delay between a transmission link pulse signal transmitted to the first coarse delay calibration unit 101 and the next air interface pulse signal to obtain a first signal (denoted as ct_data_pluse). The transmission channel associated link pulse signal transmitted to the first coarse delay calibration unit 101 is a signal (denoted as dac_data_pluse) transmitted to the first coarse delay calibration unit 101 by the transmission link channel associated pulse transfer module 120.

The first coarse delay calibration sub-unit (denoted as ct_f) is configured to perform a logic AND operation on the first signal (denoted as ct_data_pluse) and the single-cycle air interface pulse signal, perform coarse delay calibration in a case where an operation result is not 1, stop the logic AND operation until the operation result is 1, and generate a second indication signal (denoted as ct int flag), where the first indication signal (denoted as ct int flag) is configured to instruct the first precise delay calibration unit 201 to perform precise delay calibration. The first coarse delay calibration sub-unit (denoted as ct_f) triggers the coarse delay calibration interrupt each time through the rising edge of the channel associated pulse signal until the result of the sum of the channel associated pulse signal and the air interface pulse signal is 1, and ct_int_flag is generated, indicating that the coarse delay calibration is completed.

Fig. 6 is a schematic diagram of a delay calibration timing sequence of a TX link according to some embodiments of the present disclosure. As shown in Fig. 6, after the coarse delay calibration, a delay difference between the transmission channel associated pulse signal and the next air interface pulse signal is T_{d4}=T_{d1}+T_{d22}+T_{d31}, where T_{d1} is an asynchronous sampling delay between the transmission channel associated pulse signal and the air interface pulse signal, T_{d22} is an uncertain clock domain crossing delay, and T_{d31} is a sampling delay of the air interface pulse signal in a DAC digital clock domain.

**In** some embodiments, as shown in Fig. 5, the first coarse delay calibration unit 101 further includes a comparison sub-unit (denoted as counter0). The comparison sub-unit (denoted as counter0) is configured to calculate a time difference between the single-cycle air interface pulse signal and the transmission channel associated pulse signal (denoted as dac_data_pluse) transmitted to the first coarse delay calibration unit 101, so as to configure a delay between the transmission channel associated pulse signal (denoted as dac_data_pluse) transmitted to the first coarse delay calibration unit and the next air interface pulse signal according to the time difference. After the comparison sub-unit (denoted as counter0) obtains the time difference between the single-cycle air interface pulse signal and the transmission channel associated pulse signal (denoted as dac_data_pluse), successive approximation configuration is performed by adding one beat each time.

**In** some embodiments, as shown in Fig. 5, the first coarse delay calibration unit 101 further includes a first air interface pulse signal regeneration sub-unit (denoted as regen_1) and a first channel associated pulse signal regeneration sub-unit (denoted as regen_0).

The first air interface pulse signal regeneration sub-unit (denoted as regen_1) is connected to the first air interface pulse processing sub-unit (denoted as posedge0) and the first coarse delay calibration sub-unit (denoted as ct_f), and is configured to reduce the air interface pulse signal (denoted as ref_pluse) by a preset multiple according to a cycle ratio to generate a regenerated air interface pulse signal, and transmit the regenerated air interface pulse signal to the first coarse delay calibration sub-unit (denoted as ct_f). A cycle T and a preset multiple N of the air interface pulse signal (denoted as ref_pluse) are pre-configured in the first air interface pulse signal regeneration sub-unit (denoted as regen_1), and a cyclic regenerated air interface pulse signal is generated according to the cycle T and the preset multiple N of the air interface pulse signal (denoted as ref_pluse).

The first channel associated pulse signal regeneration sub-unit (denoted as regen_0) is connected to the first delay sub-unit (denoted as delay1), and is configured to reduce the transmission channel associated pulse signal (denoted as dac_data_pluse) transmitted to the first coarse delay calibration unit 101 by a preset multiple according to a cycle ratio to generate a regenerated transmission channel associated pulse signal, and transmit the regenerated transmission channel associated pulse signal to the first delay sub-unit (denoted as delay1), so that the first delay sub-unit eliminates a delay between the regenerated transmission channel associated pulse signal and the next air interface pulse signal. A cycle T and a preset multiple N of the transmission channel associated pulse signal (denoted as dac_data_pluse) are pre-configured in the first channel associated pulse signal regeneration sub-unit (denoted as regen_0), and a cyclic regenerated transmission channel associated pulse signal is generated according to the cycle T and the preset multiple N of the transmission channel associated pulse signal (denoted as dac_data_pluse).

The transmission channel associated pulse signal (denoted as dac_data_pluse) and the air interface pulse signal (denoted as ref_pluse) are reduced by N times according to a cycle ratio and are cyclically regenerated, and the coarse delay calibration process may be performed N times within one air interface pulse signal cycle, which greatly accelerates the speed of coarse delay calibration.

In some embodiments, as shown in Fig. 5, the first coarse delay calibration unit 101 further includes a first expansion sub-unit (denoted as expand1). The first expansion sub-unit (denoted as expand1) is connected to the first delay sub-unit (denoted as delay1) and the first coarse delay calibration sub-unit (denoted as ct_f), and is configured to expand a high level length of the first signal (denoted as ct_data_pluse) according to one clock cycle, and transmit the expanded first signal to the first coarse delay calibration sub-unit (denoted as ct_f), so that the first coarse delay calibration sub-unit (denoted as ct_f) performs the logical AND operation on the expanded first signal and the single-cycle air interface pulse signal. The first expansion sub-unit (denoted as expand1) expands the high level length of the channel associated pulse signal (i.e., the first signal) according to one clock cycle, thereby avoiding the uncertainty of the delay difference that may be caused by two asynchronous samplings and clock domain crossing, and ensuring that the channel associated pulse signal is earlier than the air interface pulse signal.

In conjunction with Fig. 2 and Fig. 6, after receiving the air interface pulse signal (denoted as ref_pluse), the transmission channel associated pulse generation module 110 synchronously generates the channel associated pulse signal (denoted as data_pluse). It is to be noted that the channel associated pulse signal (denoted as data_pluse) here refers to the transmission channel associated pulse signal. At this time, due to the asynchronous sampling of the air interface pulse signal (denoted as ref_pluse) by the clock, a metastable scenario may exist, and the delay difference between the channel associated pulse signal (denoted as data_pluse) and the air interface pulse signal (denoted as ref_pluse) is a T1 clock domain cycle Td1. The channel associated pulse signal (denoted as data_pluse) passes through multiple clock domains of the transmission link channel associated pulse transfer module 120 in sequence, and is controlled by the data valid enable signal. The channel associated pulse signal (denoted as data_pluse) is processed according to different working scenarios or modes, such as the multiple expansion of different extraction filters or the non-power-saving processing of Time Division Duplexing (TDD) scenarios, so as to ensure that the channel associated pulse signal is sampled by the low-level circuit and only maintains a high level for one clock cycle, and is transmitted to the low-level circuit synchronously with the data. However, due to the uncertainty of the relationship between clock domain crossing clock phases caused by each power-on or long-term clock fluctuation, there is an uncertainty in the clock cycle during each clock domain crossing transmission. When arriving at the DAC digital clock domain, the difference between the channel associated pulse signal (denoted as data_pluse) and the air interface pulse signal (denoted as ref_pluse) that generates the channel associated pulse signal is Td1+Td2, where Td2 is a fixed link delay Td21 plus the uncertain clock domain crossing delay Td22.

In the embodiments of the present disclosure, the structures of the first precise delay calibration unit 201 and the second precise delay calibration unit 202 are substantially the same. As shown in Fig. 3 and Fig. 5, the first precise delay calibration unit 201 and the second precise delay calibration unit 202 each includes a channel associated pulse processing sub-unit (denoted as posedge), a determination sub-unit (denoted as count), an air interface pulse synchronization sub-unit (denoted as sync1), a channel associated pulse synchronization sub-unit (denoted as sync0), a precise delay calibration sub-unit (not shown in the figure), and a precise delay calibration interrupt sub-unit (denoted as ft_int_gen).

The channel associated pulse processing sub-unit (denoted as posedge) is configured to receive the channel associated pulse signal transmitted by the coarse delay calibration unit in the delay calibration module where the channel associated pulse processing sub-unit is located, generate a single-cycle channel associated pulse signal according to a rising edge of the channel associated pulse signal, and transmit the single-cycle channel associated pulse signal to the first precise delay calibration interrupt sub-unit. In the first precise delay calibration unit 201, the channel associated pulse signal is the first signal transmitted by the first coarse delay calibration unit 101, and in the second precise delay calibration unit 202, the channel associated pulse signal is the second signal transmitted by the second coarse delay calibration unit 102.

The air interface pulse synchronization sub-unit (denoted as sync1) is configured to synchronize the air interface pulse signal to the corresponding clock domain, and transmit the synchronized air interface pulse signal to the determination sub-unit (denoted as count).

The channel associated pulse synchronization sub-unit (denoted as sync0) is configured to synchronize the channel associated pulse signal to the corresponding clock domain, and transmit the synchronized channel associated pulse signal to the determination sub-unit (denoted as count).

The determination sub-unit (denoted as count) is configured to perform a logic AND operation on the synchronized air interface pulse signal and the synchronized channel associated pulse signal.

The precise delay calibration sub-unit is configured to perform precise delay calibration in a case where an operation result obtained by the determination sub-unit (denoted as count) is 0. It is to be noted that the precise delay calibration sub-unit may be a functional module implemented by software.

The precise delay calibration interrupt sub-unit (denoted as ft_int_gen) is configured to generate an interrupt signal according to triggering of the single-cycle channel associated pulse signal, wherein the interrupt signal is used for stopping the precise delay calibration.

**In** some embodiments, the precise delay calibration sub-unit of the first precise delay calibration unit 201 is configured to successively add 1 to a read address of a clock domain crossing First In First Out (FIFO) memory in the transmission link to adjust a delay of the transmission channel associated pulse signal (denoted as dac_data_pluse) transmitted to the first coarse delay calibration unit 101.

In some embodiments, the precise delay calibration sub-unit of the second precise delay calibration unit 202 is configured to adjust the delay between the regenerated reception channel associated pulse signal and the next air interface pulse signal.

As shown in Fig. 3 and Fig. 5, the first precise delay calibration unit 201 of the first delay calibration module 100 includes a phase calibration sub-unit, and the second precise delay calibration unit 202 of the second delay calibration module 200 includes a phase calibration sub-unit. The phase calibration sub-unit includes a differential pulse gating sub-unit (denoted as gate_pluse) and a clock division sub-unit (denoted as clk_div), the differential pulse gating sub-unit (denoted as gate_pluse) being configured to adjust an initial phase of a clock signal in an analog domain according to a gating signal. The clock division sub-unit (denoted as clk_div) is configured to adjust an initial phase of a clock signal in a digital domain according to the initial phase of the clock signal in the analog domain.

When the coarse delay calibration is completed, the precise delay calibration is entered. The precise delay calibration includes precise delay compensation and phase calibration. The synchronized air interface pulse signal and the synchronized channel associated pulse signal perform the logic AND operation in the determination sub-unit (denoted as count). When the operation result (denoted as adc_ft_counter) is 0, the precise delay calibration sub-unit is instructed to perform precise delay compensation until the operation result is not 0, indicating that the two asynchronously sampled air interface pulses plus the uncertain clock domain crossing delay have been eliminated. At this time, the delay difference is the sum of one clock cycle T_{dac_dig} of the DAC digital clock domain and one clock cycle T_{dac_ana} of the DAC analog clock domain.

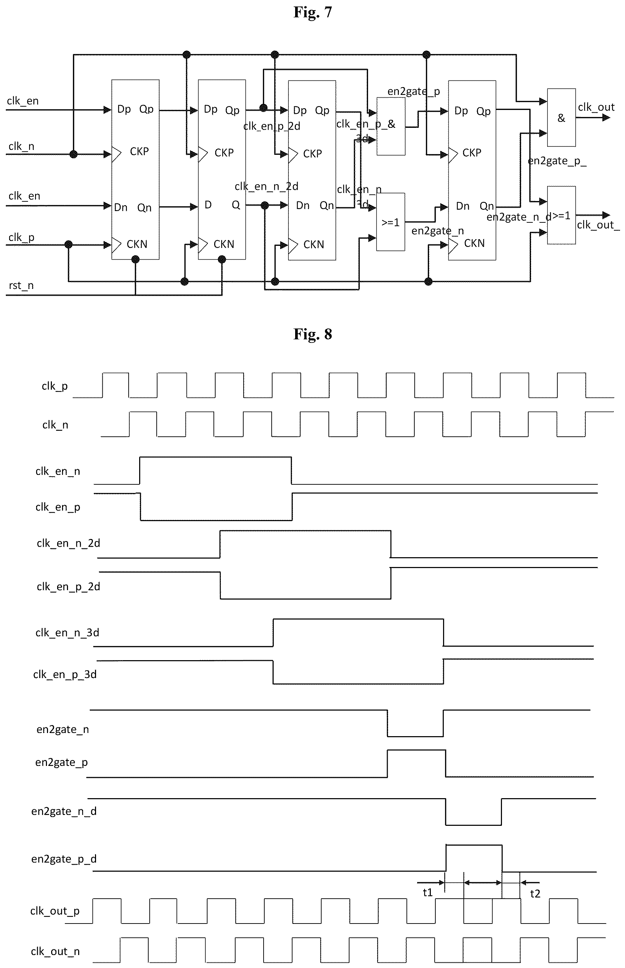

Fig. 7 is a schematic structural diagram of a gate_pluse differential circuit according to some embodiments of the present disclosure, and Fig. 8 is a schematic diagram of a timing sequence of a gate_pluse differential circuit according to some embodiments of the present disclosure. Taking the first precise delay calibration unit 201 as an example, in conjunction with Fig. 5, Fig. 6, Fig. 7, and Fig. 8, the differential pulse gating sub-unit (denoted as gate_pluse) may turn off the clock of one clock cycle each time the gating enable takes effect, and cooperate with the clock frequency division sub-unit (denoted as clk_div) to make a digital clock clk_dac_dig of a DAC adjust the frequency division initial phase of an analog clock clk_dac_ana of the DAC each time. In this way, when the calculation result reaches the maximum, the phase calibration is completed. As shown in Fig. 6, after the precise delay calibration, the delay accuracy of the transmission channel associated pulse signal and the next air interface pulse signal is T_{d5}, that is, two clock cycles T_{dac_ana} of the DAC analog clock domain.

It is to be noted that, in the second delay calibration module 200, after the second coarse delay calibration unit 102 completes the coarse delay calibration, the second precise delay calibration unit 202 performs precise delay calibration. The precise delay calibration process is the same as the precise delay calibration process performed by the first precise delay calibration unit 201, but there are the following differences.
1. The manners of adjusting the delay through precise delay compensation are different. In the second precise delay calibration unit 202, the delay between the regenerated reception channel associated pulse signal and the next air interface pulse signal is adjusted; and in the first precise delay calibration unit 201, 1 is successively added to the read address of the clock domain crossing FIFO in the transmission link to adjust the delay of the transmission pulse signal (denoted as dac_data_pluse) transmitted to the first coarse delay calibration unit.
2. The trigger signals of precise delay calibration interrupt are different. In the second precise delay calibration unit 202, the precise delay calibration interrupt is triggered by the rising edge of the air interface pulse signal (denoted as ref_pluse); and in the first precise delay calibration unit 201, the precise delay calibration interrupt is triggered by the rising edge of the channel associated pulse signal (denoted as data_pluse).

As shown in Fig. 4, after the precise delay calibration, the delay accuracy of the reception channel associated pulse signal and the next air interface pulse signal is R_{d2}, that is, two clock cycles R_{adc_ana} of the ADC analog clock domain.

According to the delay calibration apparatus of the embodiments of the present disclosure, based on the air interface pulse signal, the accuracy of delay calibration may be improved to two high-frequency clock cycles by performing delay compensation in the digital clock domain and phase calibration in the analog Analog-to-Digital and Digital-to-Analog (ADDA) high-frequency clock domain by utilizing the synchronous transmission property after the channel associated pulse signal and the link data are aligned. The delay of the channel associated pulse signal and the digital clock phase of the initial/last-level digital clock domain are adjusted by software instead of the conventional algorithm analysis after dual-point synchronous sampling, which not only greatly simplifies the calibration process and avoids a large amount of algorithm calculations, but also may quickly perform high-precision timing of the link, either in the initialization of the power-on process or in the normal operation process. The delay calibration apparatus of the embodiments of the present disclosure has a simple overall structure and may adapt to multiple channels, multiple modes, and multiple working scenarios.

The embodiments of the present disclosure may be applied to a radio frequency transceiver system of a terminal or a base station, and support high-precision delay calibration in multiple links, multiple clock domains, and multiple working modes. TX and RX multi-link extensions are supported, and the channel associated pulse signals of multiple links may be combined and generated and calibrated in the transmission channel associated pulse signal generation module 110 and the reception channel associated pulse signal calibration module 210 in a digital interface. The embodiments of the present disclosure support multi-system docking of the whole machine, and the transmission channel associated pulse signal generation module 110 and the reception channel associated pulse signal calibration module 210 in the digital interface may be transferred to a link source/end of an upstream chip system, so that high-precision calibration may be performed on the overall link delay.

The embodiments of the present disclosure are applicable to transceiver systems with high delay requirements and crossing clock domains or asynchronous clock domains, and may be widely used in radio frequency chips, terminal chips, and baseband chips with corresponding requirements.

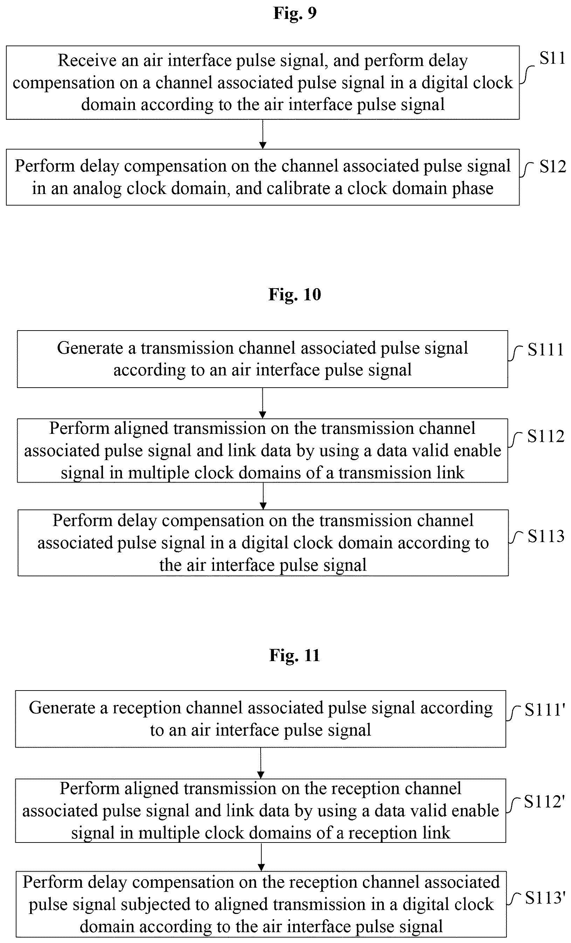

The embodiments of the present disclosure further provide a delay calibration method, applied to the delay calibration apparatus as mentioned above. As shown in Fig. 9, the delay calibration method includes the following operations.

At S11, an air interface pulse signal is received, and delay compensation is performed on a channel associated pulse signal in a digital clock domain according to the air interface pulse signal.

In this operation, a coarse delay calibration unit 10 performs delay compensation on the channel associated pulse signal in the digital clock domain according to the air interface pulse signal.

At S12, delay compensation is performed on the channel associated pulse signal in an analog clock domain, and a clock domain phase is calibrated.

In this operation, a precise delay calibration sub-unit 21 of a precise delay calibration unit 20 performs delay compensation on the channel associated pulse signal in the analog clock domain, and a phase calibration sub-unit of the precise delay calibration unit 20 calibrates the clock domain phase.

According to the delay calibration method of the embodiments of the present disclosure, based on the air interface pulse signal, the accuracy of delay calibration may be improved to two high-frequency clock cycles by performing delay compensation in the digital clock domain and phase calibration in the analog high-frequency clock domain; by adjusting the delay of the channel associated pulse signal and the digital clock phase in the digital clock domain, the conventional algorithm analysis after two-point synchronous sampling is replaced, a calibration process is simplified, the calculation amount of the algorithm is reduced, and the fast and high-precision link timing is realized; and the delay calibration apparatus has a simple overall structure and may adapt to multiple channels, multiple modes, and multiple working scenarios.

In some embodiments, as shown in Fig. 10, in a transmission link, the operation that delay compensation is performed on the channel associated pulse signal in the digital clock domain according to the air interface pulse signal (i.e., S11) includes the following operations.

At S111, a transmission channel associated pulse signal is generated according to the air interface pulse signal.

At S112, aligned transmission is performed on the transmission channel associated pulse signal and link data by using a data valid enable signal in multiple clock domains of the transmission link.

At S113, delay compensation is performed on the transmission channel associated pulse signal in the digital clock domain according to the air interface pulse signal.

In some embodiments, as shown in Fig. 11, in a reception link, the operation that delay compensation is performed on the channel associated pulse signal in the digital clock domain according to the air interface pulse signal (i.e., S11) includes the following operations.

At S111', a reception channel associated pulse signal is generated according to the air interface pulse signal.

At S112', aligned transmission is performed on the reception channel associated pulse signal and link data by using a data valid enable signal in multiple clock domains of the reception link.

At S113', delay compensation is performed on the reception channel associated pulse signal subjected to aligned transmission in the digital clock domain according to the air interface pulse signal.

In some embodiments, the operation that the reception channel associated pulse signal is generated according to the air interface pulse signal (i.e., S111') includes the following operation that: a single-cycle air interface pulse signal is generated according to a rising edge of the air interface pulse signal, and the single-cycle air interface pulse signal is reduced by a preset multiple according to a cycle ratio to generate a regenerated reception channel associated pulse signal.

The operation that delay compensation is performed on the reception channel associated pulse signal subjected to aligned transmission in the digital clock domain according to the air interface pulse signal (i.e., S113') includes the following operations.

A delay between the regenerated reception channel associated pulse signal and the next air interface pulse signal is eliminated to obtain a second signal; and a logic AND operation is performed on the second signal and the single-cycle air interface pulse signal, coarse delay calibration is performed in a case where an operation result is not 1, the logic AND operation is stopped until the operation result is 1, and a second indication signal is generated.

In some embodiments, after the second signal is obtained and before the logical AND operation is performed on the second signal and the single-cycle air interface pulse signal, the delay calibration method further includes the following operation that: a high level length of the second signal is expanded according to one clock cycle, so as to perform a logical AND operation on the expanded second signal and the single-cycle air interface pulse signal.

In some embodiments, the operation that delay compensation is performed on the transmission channel associated pulse signal in the digital clock domain according to the air interface pulse signal (i.e., S113) includes the following operations.

The single-cycle air interface pulse signal is generated according to the rising edge of the air interface pulse signal; a delay between the transmission channel associated pulse signal transmitted to a first coarse delay calibration unit and the next air interface pulse signal is eliminated to obtain a first signal; and a logic AND operation is performed on the first signal and the single-cycle air interface pulse signal, coarse delay calibration is performed in a case where an operation result is not 1, the logic AND operation is stopped until the operation result is 1, and a first indication signal is generated.

In some embodiments, before the delay between the transmission channel associated pulse signal transmitted to the first coarse delay calibration unit and the next air interface pulse signal is eliminated, the delay calibration method further includes the following operation that: a time difference between the single-cycle air interface pulse signal and the transmission channel associated pulse signal transmitted to the first coarse delay calibration unit is calculated, so as to configure the delay between the transmission channel associated pulse signal transmitted to the first coarse delay calibration unit and the next air interface pulse signal according to the time difference.

In some embodiments, before the delay between the transmission channel associated pulse signal transmitted to the first coarse delay calibration unit and the next air interface pulse signal is eliminated, the delay calibration method further includes the following operations that: the air interface pulse signal is reduced by a preset multiple according to a cycle ratio to generate a regenerated air interface pulse signal; and the transmission channel associated pulse signal transmitted to the first coarse delay calibration unit is reduced by a preset multiple according to a cycle ratio to generate a regenerated transmission channel associated pulse signal, so as to eliminate a delay between the regenerated transmission channel associated pulse signal and the next air interface pulse signal.

In some embodiments, before the logical AND operation is performed on the first signal and the single-cycle air interface pulse signal, the delay calibration method further includes the following operation that: a high level length of the first signal is expanded according to one clock cycle, so as to perform a logical AND operation on the expanded first signal and the single-cycle air interface pulse signal.

In some embodiments, after the coarse delay calibration is performed, the delay calibration method further includes the following operations.

The channel associated pulse signal is received, and a single-cycle channel associated pulse signal is generated according to a rising edge of the channel associated pulse signal, where the channel associated pulse signal is the first signal or the second signal.

The air interface pulse signal is synchronized to the corresponding clock domain, and the channel associated pulse signal is synchronized to the corresponding clock domain.

A logical AND operation is performed on the synchronized air interface pulse signal and the synchronized channel associated pulse signal, and precise delay calibration is performed in a case where an operation result is 0, where an interrupt signal is generated according to triggering of the single-cycle channel associated pulse signal, wherein the interrupt signal is used for stopping the precise delay calibration.

In some embodiments, the operation that coarse delay calibration is performed includes the following operation.

1 is successively added to a read address of a clock domain crossing FIFO in the transmission link to adjust a delay of the transmission channel associated pulse signal transmitted to the first coarse delay calibration unit. Or.

The delay between the regenerated reception channel associated pulse signal and the next air interface pulse is adjusted.

In some embodiments, the operation that the clock domain phase is calibrated includes the following operations.

An initial phase of a clock signal in an analog domain is adjusted according to a gating signal.

An initial phase of a clock signal in a digital domain is adjusted according to the initial phase of the clock signal in the analog domain.

In order to clearly illustrate the solution of the embodiment of the present disclosure, the delay calibration process of the embodiment of the present disclosure is described in detail below through a specific example. The specific operations of the delay calibration process are as follows.
1. According to the actual chip needs, TX and RX delay calibration is started after power-on.
2. According to the working scenario of the product application, the pulse cycle, link configuration, initial calibration value, register and other parameters related to the TX and RX channel associated pulse generation and calibration are initialized and configured through software.
3. The air interface pulse signal is circularly transmitted outside, the channel associated pulse signal of a TX link is directly generated by using a TX channel associated pulse generator, and the channel associated pulse signal of an RX link is generated by utilizing an ADC calibration unit through coarse delay calibration and precise delay calibration.

A coarse delay calibration process of an ADC is as follows: the rising edge of the air interface pulse signal triggers the ADC coarse delay calibration interrupt of the software, and the software adds the delay by one beat each time until a result of the sum of the channel associated pulse signal and the air interface pulse signal is 1, indicating that the coarse delay calibration is completed.

A precise delay calibration process of the ADC is as follows: the rising edge of the air interface pulse signal triggers the ADC precise delay calibration interrupt of the software, and if a counter value of the sum of the channel associated pulse signal and the air interface pulse signal is 0, the delay is continued to be added by one beat each time, and coarse delay calibration is performed if the counter value is not 0, the software performs a process of closing and opening the clock gate control to adjust the phase until the counter value is equal to a predetermined threshold value, indicating that the precise delay calibration is completed.
4. The TX and RX channel associated pulse signals are transmitted in the link and arrive at a DAC calibration unit and an RX channel associated pulse signal calibrator respectively.
5. The coarse delay calibration and the precise delay calibration are performed in the DAC calibration unit, and coarse delay calibration is performed in the RX channel associated pulse calibrator.

A coarse delay calibration process of a DAC is as follows: the rising edge of the channel associated pulse signal triggers the DAC coarse delay calibration interrupt of the software, after the counter value of a comparison module is read, a similar delay value is set, and then the software adds the delay by one beat each time until the result of the sum of the channel associated pulse signal and the air interface pulse signal is 1, indicating that the coarse delay calibration is completed.

A precise delay calibration process of the DAC is as follows: the rising edge of the channel associated pulse signal triggers the DAC precise delay calibration interrupt of the software, and when a counter value of the sum of the channel associated pulse signal and the air interface pulse signal is 0, 1 is successively added to the read address of the clock domain crossing FIFO of the DAC to adjust the channel associated pulse delay, and precise delay compensation is performed. When the counter value is not 0, the software performs a process of closing and opening the clock gate control to adjust the phase until the counter value is equal to a predetermined threshold value, indicating that the precise delay calibration is completed. The coarse delay calibration in the RX channel associated pulse calibrator is the same as the coarse delay calibration process of the DAC.

6. The delay calibration process is exited, the next delay detection calibration of the TX and RX links in the normal operation process is waited, and S2 to S5 are repeated.

Exemplary embodiments have been disclosed herein, and although specific terms are employed, they are used and should be interpreted only in a general illustrative sense and not for limiting purposes. In some examples, it is apparent to those having ordinary skill in the art that, unless otherwise explicitly stated, features, characteristics, and/or elements described in conjunction with a particular embodiment may be used alone or in combination with features, characteristics, and/or elements described in conjunction with other embodiments. Therefore, it is to be understood by those having ordinary skill in the art that various changes in form and details may be made without departing from the scope of the present disclosure as set forth in the appended claims.

## Claims

1. A delay calibration apparatus, comprising a delay calibration module, wherein the delay calibration module comprises a coarse delay calibration unit and a precise delay calibration unit;
the coarse delay calibration unit is configured to receive an air interface pulse signal, and perform delay compensation on a channel associated pulse signal in a digital clock domain according to the air interface pulse signal;
the precise delay calibration unit comprises a precise delay calibration sub-unit and a phase calibration sub-unit;
the precise delay calibration sub-unit is configured to perform delay compensation on the channel associated pulse signal in an analog clock domain after the coarse delay calibration unit performs the delay compensation on the channel associated pulse signal in the digital clock domain according to the air interface pulse signal; and
the phase calibration sub-unit is configured to calibrate a clock domain phase after the precise delay calibration sub-unit performs the delay compensation on the channel associated pulse signal in the analog clock domain.

2. The delay calibration apparatus according to claim 1, wherein the delay calibration apparatus further comprises a transmission link, and the delay calibration module comprises a first delay calibration module, the first delay calibration module being located in the transmission link;
the coarse delay calibration unit is a first coarse delay calibration unit, the precise delay calibration unit is a first precise delay calibration unit, and the channel associated pulse signal is a transmission channel associated pulse signal;
the transmission link further comprises a transmission channel associated pulse generation module and a transmission link channel associated pulse transfer module;
the transmission channel associated pulse generation module is configured to receive the air interface pulse signal, and generate the transmission channel associated pulse signal according to the air interface pulse signal; and
the transmission link channel associated pulse transfer module is configured to perform aligned transmission on the transmission channel associated pulse signal and link data by using a data valid enable signal in multiple clock domains of the transmission link, and transmit the transmission channel associated pulse signal and link data to the first coarse delay calibration unit of the first delay calibration module.

3. The delay calibration apparatus according to claim 1 or 2, wherein the delay calibration apparatus further comprises a reception link, and the delay calibration module comprises a second delay calibration module, the second delay calibration module being located in the reception link;
the channel associated pulse signal is a reception channel associated pulse signal, the precise delay calibration unit is a second precise delay calibration unit, the coarse delay calibration unit is a second coarse delay calibration unit, and the second coarse delay calibration unit is further configured to generate the reception channel associated pulse signal according to the air interface pulse signal after receiving the air interface pulse signal;
the reception link further comprises a reception channel associated pulse calibration module and a reception link channel associated pulse transfer module;
the reception link channel associated pulse transfer module is configured to perform aligned transmission on the reception channel associated pulse signal and link data by using a data valid enable signal in multiple clock domains of the reception link, and transmit the reception channel associated pulse signal and the link data to the reception channel associated pulse calibration module; and
the reception channel associated pulse calibration module is configured to perform delay compensation on the received channel associated pulse signal in the digital clock domain according to the air interface pulse signal.

4. The delay calibration apparatus according to claim 3, wherein the second coarse delay calibration unit comprises a second air interface pulse processing sub-unit, a second channel associated pulse signal regeneration sub-unit, a second delay sub-unit, and a second coarse delay calibration sub-unit;
the second air interface pulse processing sub-unit is configured to generate a single-cycle air interface pulse signal according to a rising edge of the air interface pulse signal;
the second channel associated pulse signal regeneration sub-unit is respectively connected to the second air interface pulse processing sub-unit and the second delay sub-unit, and is configured to reduce the single-cycle air interface pulse signal transmitted by the second air interface pulse processing sub-unit by a preset multiple according to a cycle ratio to generate a regenerated reception channel associated pulse signal, and transmit the regenerated reception channel associated pulse signal to the second delay sub-unit;
the second delay sub-unit is configured to eliminate a delay between the regenerated reception channel associated pulse signal and a next air interface pulse signal to obtain a second signal; and
the second coarse delay calibration sub-unit is configured to perform a logic AND operation on the second signal and the single-cycle air interface pulse signal, perform coarse delay calibration in a case where an operation result is not 1, stop the logic AND operation until the operation result is 1, and generate a second indication signal.

5. The delay calibration apparatus according to claim 4, wherein the second coarse delay calibration unit further comprises a second expansion sub-unit;
the second expansion sub-unit is connected to the second delay sub-unit and the second coarse delay calibration sub-unit, and is configured to expand a high level length of the second signal according to one clock cycle, and transmit the expanded second signal to the second coarse delay calibration sub-unit, so that the second coarse delay calibration sub-unit performs the logical AND operation on the expanded second signal and the single-cycle air interface pulse signal.

6. The delay calibration apparatus according to claim 4, wherein the first coarse delay calibration unit comprises a first air interface pulse processing sub-unit, a first delay sub-unit, and a first coarse delay calibration sub-unit;
the first air interface pulse processing sub-unit is configured to generate the single-cycle air interface pulse signal according to the rising edge of the air interface pulse signal;
the first delay sub-unit is configured to eliminate a delay between the transmission channel associated pulse signal transmitted to the first coarse delay calibration unit and the next air interface pulse signal to obtain a first signal; and
the first coarse delay calibration sub-unit is configured to perform a logic AND operation on the first signal and the single-cycle air interface pulse signal, perform coarse delay calibration in a case where an operation result is not 1, stop the logic AND operation until the operation result is 1, and generate a first indication signal.

7. The delay calibration apparatus according to claim 6, wherein the first coarse delay calibration unit further comprises a comparison sub-unit;
the comparison sub-unit is configured to calculate a time difference between the single-cycle air interface pulse signal and the transmission channel associated pulse signal transmitted to the first coarse delay calibration unit, so as to configure the delay between the transmission channel associated pulse signal transmitted to the first coarse delay calibration unit and the next air interface pulse signal according to the time difference.

8. The delay calibration apparatus according to claim 6, wherein the first coarse delay calibration unit further comprises a first air interface pulse regeneration sub-unit and a first channel associated pulse signal regeneration sub-unit;
the first air interface pulse signal regeneration sub-unit is connected to the first air interface pulse processing sub-unit and the first coarse delay calibration sub-unit, and is configured to reduce the air interface pulse signal by a preset multiple according to a cycle ratio to generate a regenerated air interface pulse signal, and transmit the regenerated air interface pulse signal to the first coarse delay calibration sub-unit; and
the first channel associated pulse signal regeneration sub-unit is connected to the first delay sub-unit, and is configured to reduce the transmission channel associated pulse signal transmitted to the first coarse delay calibration unit by a preset multiple according to a cycle ratio to generate a regenerated transmission channel associated pulse signal, and transmit the regenerated transmission channel associated pulse signal to the first delay sub-unit, so that the first delay sub-unit eliminates a delay between the regenerated transmission channel associated pulse signal and the next air interface pulse signal.

9. The delay calibration apparatus according to claim 6, wherein the first coarse delay calibration unit further comprises a first expansion sub-unit;
the first expansion sub-unit is connected to the first delay sub-unit and the first coarse delay calibration sub-unit, and is configured to expand a high level length of the first signal according to one clock cycle, and transmit the expanded first signal to the first coarse delay calibration sub-unit, so that the first coarse delay calibration sub-unit performs the logical AND operation on the expanded first signal and the single-cycle air interface pulse signal.

10. The delay calibration apparatus according to claim 6, wherein the first precise delay calibration unit and the second precise delay calibration unit each comprises a channel associated pulse processing sub-unit, a determination sub-unit, an air interface pulse synchronization sub-unit, a channel associated pulse synchronization sub-unit, the precise delay calibration sub-unit, and a precise delay calibration interrupt sub-unit;
the channel associated pulse processing sub-unit is configured to receive the channel associated pulse signal transmitted by the coarse delay calibration unit in the delay calibration module where the channel associated pulse processing sub-unit is located, generate a single-cycle channel associated pulse signal according to a rising edge of the channel associated pulse signal, and transmit the single-cycle channel associated pulse signal to the first precise delay calibration interrupt sub-unit, wherein in the first precise delay calibration unit, the channel associated pulse signal is the first signal, and in the second precise delay calibration unit, the channel associated pulse signal is the second signal;
the air interface pulse synchronization sub-unit is configured to synchronize the air interface pulse signal to the corresponding clock domain, and transmit the synchronized air interface pulse signal to the determination sub-unit;
the channel associated pulse synchronization sub-unit is configured to synchronize the channel associated pulse signal to the corresponding clock domain, and transmit the synchronized channel associated pulse signal to the determination sub-unit;
the determination sub-unit is configured to perform a logic AND operation on the synchronized air interface pulse signal and the synchronized channel associated pulse signal;
the precise delay calibration sub-unit is configured to perform precise delay calibration in a case where an operation result obtained by the determination sub-unit is 0; and
the precise delay calibration interrupt sub-unit is configured to generate an interrupt signal according to triggering of the single-cycle channel associated pulse signal, wherein the interrupt signal is used for stopping the precise delay calibration.

11. The delay calibration apparatus according to claim 10, wherein the precise delay calibration sub-unit of the first precise delay calibration unit is configured to successively add 1 to a read address of a clock domain crossing First In First Out, FIFO, memory in the transmission link to adjust a delay of the transmission channel associated pulse signal transmitted to the first coarse delay calibration unit.

12. The delay calibration apparatus according to claim 10, wherein the precise delay calibration sub-unit of the second precise delay calibration unit is configured to adjust the delay between the regenerated reception channel associated pulse signal and the next air interface pulse signal.

13. The delay calibration apparatus according to any one of claims 1 to 12, wherein the phase calibration sub-unit comprises a differential pulse gating sub-unit and a clock frequency division sub-unit;
the differential pulse gating sub-unit is configured to adjust an initial phase of a clock signal in an analog domain according to a gating signal; and
the clock frequency division sub-unit is configured to adjust an initial phase of a clock signal in a digital domain according to the initial phase of the clock signal in the analog domain.

14. A delay calibration method, applied to the delay calibration apparatus according to any one of claims 1 to 13, wherein the delay calibration method comprises:
receiving an air interface pulse signal, and performing delay compensation on a channel associated pulse signal in a digital clock domain according to the air interface pulse signal; and
performing delay compensation on the channel associated pulse signal in an analog clock domain, and calibrating a clock domain phase.

15. The delay calibration method according to claim 14, wherein in a transmission link, the performing delay compensation on a channel associated pulse signal in a digital clock domain according to the air interface pulse signal comprises:
generating a transmission channel associated pulse signal according to the air interface pulse signal; and
performing aligned transmission on the transmission channel associated pulse signal and link data by using a data valid enable signal in multiple clock domains of the transmission link; and
performing delay compensation on the transmission channel associated pulse signal in the digital clock domain according to the air interface pulse signal.

16. The delay calibration method according to claim 14 or 15, wherein in a reception link, the performing delay compensation on a channel associated pulse signal in a digital clock domain according to the air interface pulse signal comprises:
generating a reception channel associated pulse signal according to the air interface pulse signal;
performing aligned transmission on the reception channel associated pulse signal and link data by using a data valid enable signal in multiple clock domains of the reception link; and
performing delay compensation on the reception channel associated pulse signal subjected to aligned transmission in the digital clock domain according to the air interface pulse signal.

17. The delay calibration method according to claim 16, applied to the delay calibration apparatus according to any one of claims 4 to 13, wherein the generating a reception channel associated pulse signal according to the air interface pulse signal comprises:
generating a single-cycle air interface pulse signal according to a rising edge of the air interface pulse signal, and reducing the single-cycle air interface pulse signal by a preset multiple according to a cycle ratio to generate a regenerated reception channel associated pulse signal;
the performing delay compensation on the reception channel associated pulse signal subjected to aligned transmission in the digital clock domain according to the air interface pulse signal comprises:
eliminating a delay between the regenerated reception channel associated pulse signal and the next air interface pulse signal to obtain a second signal; and
performing a logic AND operation on the second signal and the single-cycle air interface pulse signal, performing coarse delay calibration in a case where an operation result is not 1, stopping the logic AND operation until the operation result is 1, and generating a second indication signal.

18. The delay calibration method according to claim 17, applied to the delay calibration apparatus according to any one of claims 5 to 13, wherein after the second signal is obtained and before the logical AND operation is performed on the second signal and the single-cycle air interface pulse signal, the delay calibration method further comprises:
expanding a high level length of the second signal according to one clock cycle, so as to perform a logical AND operation on the expanded second signal and the single-cycle air interface pulse signal.

19. The delay calibration method according to claim 17, applied to the delay calibration apparatus according to any one of claims 6 to 13, wherein the performing delay compensation on the transmission channel associated pulse signal in the digital clock domain according to the air interface pulse signal comprises:
generating the single-cycle air interface pulse signal according to the rising edge of the air interface pulse signal;
eliminating a delay between the transmission channel associated pulse signal transmitted to a first coarse delay calibration unit and the next air interface pulse signal to obtain a first signal; and
performing a logic AND operation on the first signal and the single-cycle air interface pulse signal, performing coarse delay calibration in a case where an operation result is not 1, stopping the logic AND operation until the operation result is 1, and generating a first indication signal.

20. The delay calibration method according to claim 19, applied to the delay calibration apparatus according to any one of claims 7 to 13, wherein before the delay between the transmission channel associated pulse signal transmitted to the first coarse delay calibration unit and the next air interface pulse signal is eliminated, the delay calibration method further comprises:
calculating a time difference between the single-cycle air interface pulse signal and the transmission channel associated pulse signal transmitted to the first coarse delay calibration unit, so as to configure the delay between the transmission channel associated pulse signal transmitted to the first coarse delay calibration unit and the next air interface pulse signal according to the time difference.

21. The delay calibration method according to claim 19, applied to the delay calibration apparatus according to any one of claims 8 to 13, wherein before the delay between the transmission channel associated pulse signal transmitted to the first coarse delay calibration unit and the next air interface pulse signal is eliminated, the delay calibration method further comprises:
reducing the air interface pulse signal by a preset multiple according to a cycle ratio to generate a regenerated air interface pulse signal;
reducing the transmission channel associated pulse signal transmitted to the first coarse delay calibration unit by a preset multiple according to a cycle ratio to generate a regenerated transmission channel associated pulse signal, so as to eliminate a delay between the regenerated transmission channel associated pulse signal and the next air interface pulse signal.

22. The delay calibration method according to claim 19, applied to the delay calibration apparatus according to any one of claims 9 to 13, wherein before the logical AND operation is performed on the first signal and the single-cycle air interface pulse signal, the delay calibration method further comprises:
expanding a high level length of the first signal according to one clock cycle, so as to perform a logical AND operation on the expanded first signal and the single-cycle air interface pulse signal.

23. The delay calibration method according to claim 19, applied to the delay calibration apparatus according to any one of claims 10 to 13, wherein after the coarse delay calibration is performed, the delay calibration method further comprises:
receiving the channel associated pulse signal, and generating a single-cycle channel associated pulse signal according to a rising edge of the channel associated pulse signal, wherein the channel associated pulse signal is the first signal or the second signal;
synchronizing the air interface pulse signal to the corresponding clock domain, and synchronizing the channel associated pulse signal to the corresponding clock domain; and
performing a logical AND operation on the synchronized air interface pulse signal and the synchronized channel associated pulse signal, and performing precise delay calibration in a case where an operation result is 0, wherein an interrupt signal is generated according to triggering of the single-cycle channel associated pulse signal, wherein the interrupt signal is used for stopping the precise delay calibration.

24. The delay calibration method according to claim 23, wherein the performing precise delay calibration comprises:
successively adding 1 to a read address of a clock domain crossing First In First Out, FIFO, memory in the transmission link to adjust a delay of the transmission channel associated pulse signal transmitted to the first coarse delay calibration unit; or,
adjusting the delay between the regenerated reception channel associated pulse signal and the next air interface pulse.

25. The delay calibration method according to any one of claims 14 to 24, wherein the calibrating a clock domain phase comprises:
adjusting an initial phase of a clock signal in an analog domain according to a gating signal; and
adjusting an initial phase of a clock signal in a digital domain according to the initial phase of the clock signal in the analog domain.
